# EUROPEAN PATENT APPLICATION

(11) **EP 0 800 207 A1**
(43) Date of publication of application: **08.10.1997**
(21) Application number: 97301958.1
(22) Date of filing: 21.03.1997
(51) Int. Cl.: H01L 21/86, H01L 21/764, H01L 29/786, H01L 21/336, H01L 27/12

(54) **Semiconductor devices**

(30) Priority: 03.04.1996 GB 9607060; 17.02.1997 GB 9703275
(71) Applicant: PLESSEY SEMICONDUCTORS LIMITED, Swindon, Wiltshire SN2 2QW (GB)
(72) Inventor: Kerr, John Anthony, Lincoln LN6 0XT (GB)
(74) Representative: Walker, Andrew John

(57) **Abstract**

A method of edge passivating silicon islands for stabilised FET devices comprises forming masks (48) on a layer of silicon (44), introducing a conductivity modifier, such as boron into areas (56, 58) of the layer (44) unprotected by the masks (48), depositing a masking layer which is then partially etched away to widen the masks, etching away silicon which is unprotected by the widened masks (48, 64) to form silicon island and then removing the masks (48) to expose the modified silicon islands. The silicon islands are then processed into FET devices in a conventional manner.

## Description

This invention relates to semiconductors. It is particularly, but not exclusively, related to stabilised field effect transistors and to a method of making them.

Semiconductor devices can suffer from problems of instabilities. An example of such a problem is excessive leakage current with zero gate voltage in silicon-on-sapphire or silicon-on-insulator field effect transistor (FET) devices, This problem occurs particularly at the edges of a silicon channel region in a FET device, for example at a locos or a mesa edge. At the top edge of a mesa the channel is being acted upon by a gate disposed above and to the side of the channel, thus reducing the threshold voltage in this region. At the bottom edge of a mesa the silicon thins towards the substrate and consequently the threshold voltage decreases rapidly. This causes these areas to suffer from premature turn-on. These problems occur in N and P-channel FET devices, particularly in N-channel devices.

An attempt to overcome these problems is disclosed in GB1447849. This discloses doping edges of the channel region in a FET device to provide a higher concentration of active carriers (conductivity modifiers) at the edges. This raises the threshold voltage at the edge regions above that present in a normally operating FET device. However, a problem with this approach is that it is very difficult to passivate fully along the edge of the channel because the peak of the distribution of implanted conductivity modifiers is always buried within the silicon channel. The depth of implantation into the silicon at which peak distribution will occur is determined by the ion energy. Therefore at the bottom edge of the channel the silicon is not sufficiently modified with conductivity modifiers because the peak distribution of the modifiers lies beneath the silicon and within the substrate. Furthermore this approach does not solve the problem of the "two gate effect" on the top edge of the channel. The method according to GB1447849 leads to insufficient modification of the silicon at the top and bottom edges of the channel.

It is an aim of the invention to produce a more effective method of introducing conductivity modifiers to edge passivate a semiconductor device.

According to a first aspect the invention provides a method of stabilising a semiconductor device the method comprising the steps of: forming a layer of semiconductor material on a substrate; forming an intermediate layer on the semiconductor layer; forming at least one mask region on a portion of the intermediate layer, the mask region being conductivity modifier impermeable; introducing conductivity modifiers into unprotected regions of the semiconductor layer; changing the dimensions of the or each mask region; and etching back unprotected regions of the semiconductor layer to form at least one semiconductor island.

The steps in the foregoing paragraph may occur in an order other than that set out. For example introduction of conductivity modifiers may occur after the or each semiconductor island has been formed.

The or each mask region may be decreased in size. Preferably the or each mask region is increased in size. Conveniently the or each mask may be increased in size by depositing a spacer along at least one mask side. Preferably spacers are deposited along opposing mask sides. The spacer or spacers may comprise resist material.

The term impermeable means able to stop the introduction of a sufficient amount of conductivity modifiers to prevent modification of the semiconductor layer.

The term "unprotected" means not masked by the or each mask region. The term "protected" means the opposite.

Preferably the intermediate layer is conductivity-modifier permeable. Advantageously the intermediate layer absorbs energy of the conductivity modifiers such that they travel to a lesser depth in the semiconductor layer than they would do in the absence of the intermediate layer. Preferably the intermediate layer comprises a thermal oxide.

The size of the unprotected regions of the layer may change during carrying out of the method.

Preferably the method relates to passivating at least one edge of the or each semiconductor island.

If the or each mask is increased in size after introduction of conductivity modifier, the regions of modified semiconductor under the or each mask may be protected against subsequent etching. It is relatively easy to control the extent to which the or each mask is increased in size and consequently it is easy to define which parts of the modified semiconductor are etched away and which remain. This means that semiconductor islands can readily be produced having a carefully tailored conductivity modifier distribution which provides more effective edge passivation.

Once modified the or each island may be processed further to produce the semiconductor device. Preferably the device is a stabilised FET device. Further steps may include at least one of forming source, drain and channel regions in the or each island, depositing insulating and gate layers as required and forming electrodes on the island and/or the gate.

Preferably the layer of semiconductor material is a single crystal. It may be epitaxially related to the substrate.

Preferably the or each mask region comprises a low temperature deposited oxide or nitride layer.

Preferably the conductivity modifiers are atoms or ions of any P-type dopant including aluminium or boron. The conductivity modifiers may be introduced by ion bombardment. There may be a plurality of implants. There may be a series of overlapping implants in which at least two of the series have different energies and/or provide different doses. This can produce overlapping distributions of conductivity modifiers.

By using a series of implants of different energies and/or doses the distribution of conductivity modifiers can be controlled to produce a uniform doping distribution through the semiconductor layer. The implants may produce an increased concentration in a region of the semiconductor layer.

Preferably areas of the semiconductor layer which are to form P-channel devices are protected against introduction of conductivity modifiers. Alternatively a similar procedure could be followed to stabilise P-channel devices using appropriate modifiers.

According to a second aspect the invention provides a semiconductor device made using a method in accordance with the first aspect of the invention.

An example of the invention will now be described, by way of example only, with reference to the accompanying figures in which:
Figure 1 shows a schematic representation of a known method of making a FET device;
Figure 2 shows a fragmentary cross sectional view of part of a known FET;
Figures 3 to 6 show steps in the method according to the invention; and
Figures 7 and 8 show steps in an alternative method according to the invention.

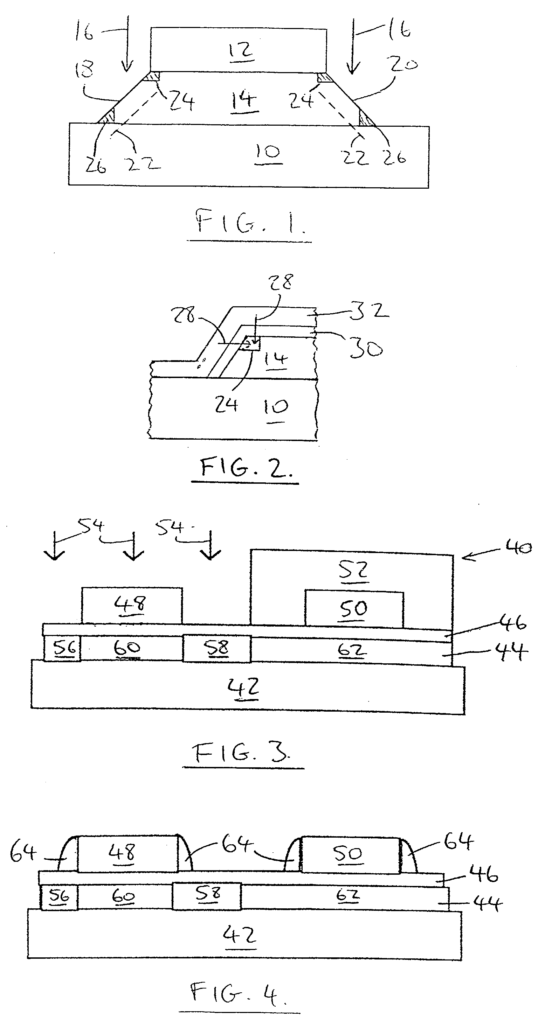

Figure 1 shows a known method of edge passivating a semiconductor device. This method involves expitaxially growing a silicon layer (0.3µm thick) on a substrate 10 which is conventionally sapphire and about 500µm thick. A resist mask 12 is deposited on the layer and etching is carried out to leave a silicon island 14.

A conductivity modifier such as boron, is implanted into the edges of the silicon island 14 by ion bombardment (shown schematically by arrows 16).

A problem with this method is that it is very difficult to passivate along a whole edge (18, 20) of the island because the peak of the implanted modifier distribution will always lie within the silicon. The depth at which the peak lies will depend upon the energy of the ions which are used. The peak of the distribution on each edge of the island 14 is represented by dotted lines (22) in Figure 1. This method results in the concentration of modifier being insufficient in areas at the top 24 and the bottom 26 of the edges.

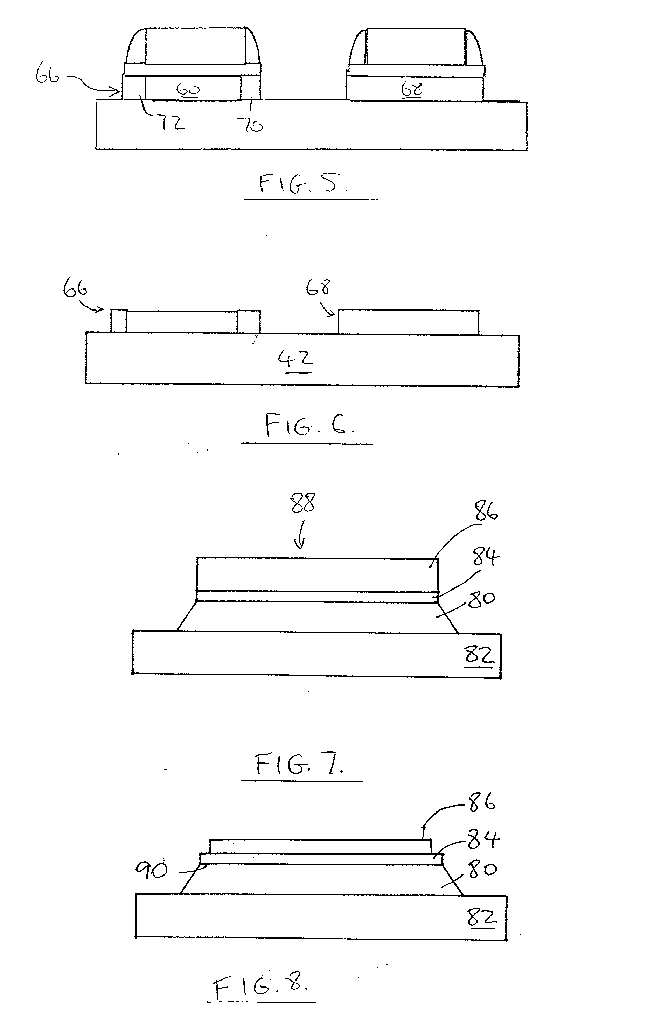

At the top, the amount of modifier received in the area 24 is limited by the presence of the resist mask 12. Although it is possible to use a high temperature drive in to diffuse the modifier underneath the resist mask 12, a high temperature drive is not suitable if the substrate 10 is sapphire because it would also diffuse aluminium out of the sapphire into the silicon thus forming a short circuit for P-channel devices. In any case an additional high temperature step is not desirable irrespective of the substrate. Furthermore the area 24 is particularly susceptible to leakage because once the device is fabricated the structure in the area 24 is two dimensional in nature. This is illustrated in Figure 2. This shows a fragmentary view of part of a device having a substrate 10, an island 14, an insulating oxide layer 30 and a polysilicon gate 32. Area 24 is controlled in effect by two "gates" one at the top and one on the side. Arrows 28 represent the influence exerted by these "gates". Accordingly area 24 needs a greater concentration of modifier to increase the threshold voltage and thus reduce leakage.

Referring back to Figure 1, area 26 has insufficient modifier concentration because as it thins towards the edge of the island 14, the peak distribution of the modifier is present beneath the area 26, in the substrate 10. As the edge of the island is approached the modifier concentration in the silicon reduces.

Figures 3 to 6 show steps in a method according to the invention.

Figure 3 shows a structure 40 which has been fabricated prior to modifier implantation. The structure 40 comprises a sapphire substrate 42 on which is deposited a silicon layer 44. Alternatively the substrate could be the buried oxide of a silicon-on-insulator (SOI). A thermal oxide layer 46 is grown on the silicon layer 44. A low temperature oxide or nitride layer (0.5µm thick) is deposited on the thermal oxide layer 46. The low temperature oxide or nitride layer is etched away to define island masks 48, 50. Areas 50 which are to form P-channel devices do not usually require implantation of modifier and so they are protected with a resist 52.

Deposition and etching steps are carried out by standard techniques well known in the art. For example the low temperature oxide layer 48 is deposited by plasma enhanced chemical vapour deposition (PECVD).

The structure 40 is then implanted with a series of overlapping implants (shown by arrows 54) of a modifier such as boron. If boron is used it may be in the form of boron ions or boron difluoride. By using a series of implants of different energies or doses, a uniform modifier distribution can be built up through the regions of the silicon layer 44 which are exposed to the implants. This is done by using implants of different energies to produce, sequentially, peaks of overlapping distributions through the silicon layer 44. A low energy implant can be used to provide an increased modifier concentration at the top of implanted regions of silicon layer 44. This would be to modify a region equivalent to region 24 in Figure 2. A suitable implant would be 5 x 10¹² - 5 x 10¹³ cm⁻² of BF₂ at 20 keV. A high energy implant of boron ions 5 x 10¹² - 5 x 10 ¹³ cm⁻² at 100 keV would be used to modify a region equivalent to region 26 in Figure 1. Implanted regions of the silicon layer 44 are indicated by numerals 56 and 58. The other regions 60, 62 are protected by the mask 48 and resist 52 respectively and so are not modified. A suitable modifier concentration in the implanted regions 56 and 58 is in the region of 10¹⁷ - 10¹⁸ cm⁻³.

The thermal oxide layer 46 reduces the energy of the modifier before it passes into the silicon layer 44. In this way more modifier comes to a halt and is contained within a region near the top of the silicon layer than would be the case in the absence of the layer 46.

Following implantation resists 52 are etched away leaving the masks 48, 50. A further masking layer comprising a suitable material for example silicon dioxide or silicon nitride, is formed on the oxide layer 46 and over the masks 48, 50. This layer is etched away by an anisotropic etch back process to produce the structure shown in Figure 4 in which spacers 64 are formed along the edges of the masks 48, 50. The spacers extend laterally in the region of 0.1 to 0.3µm. In this structure the masks 48, 50 have been widened by the presence of the spacers 64.

It is preferred that a combination of oxides (for the masks 48, 50) and nitrides (for the spacers 64) be used to provide widened masks 48, 50, 64. The combination provides more control in deposition and etching.

The silicon islands 66, 68 are now formed by an etching process of the silicon layer 44 which produces the structure shown in Figure 5. Island 66 comprises the unmodified region 60 flanked on each side by modified regions 70, 72 which were part of implanted regions 56 and 58. Island 68 comprises a part of the unmodified silicon layer. A suitable etching process for etching away any of the layers would be plasma etching.

It will be noted from figure 5 that the masks remain on the silicon islands during the etching process and are left at the end of the step in which the silicon islands are formed. It is only afterwards that the masks are removed. In this way the silicon islands are completely protected from damage caused by etching during their fabrication.

Following formation of the silicon islands the sacrificial layers 46, 48, 50, 64 are stripped away to leave islands 66 and 68 on the substrate 42 as shown in Figure 6. (Island 66 is to fabricate an N-channel device and island 68 is to fabricate a P-channel device). The island or islands then undergo processing steps to produce FET devices.

Using this method enables the distribution of modifier in the edges of the silicon island 66 to be carefully controlled. Furthermore, because implanting the modifier is carried out before etching and formation of the silicon island 66 the amount of etching which is done to form the silicon island 66 is controlled in order to expose the peak distribution of modifier at or near the etched surface of the silicon island 66.

Using the spacers 64 enables accurate formation and alignment of the modified regions at the edge of the island 66. It is effectively a self-aligning process. Furthermore they obviate the need for a high temperature diffusion drive in to drive modifier underneath the mask 48.

An alternative method is shown in Figures 7 and 8. A silicon layer 80 is grown on a substrate 82. An intermediate layer 84 is grown on the silicon layer 80. A resist layer 86 is deposited on the intermediate layer 84, developed and then etching is carried out to leave a silicon island 88 as shown in Figure 7.

The resist layer 86 is thinned by a thickness of 0.1 to 0.2µm by an oxygen plasma etch process to leave the structure shown in Figure 8. It is baked at a higher than normal baking temperature to harden it which makes it resistant to further photolithography light exposure. This enables another resist layer to be applied and defined to protect P-channel areas in order to produce P-channel devices such as that shown in Figure 6 by numeral 68.

The island has been defined prior to the edge passivation by implantation of conductivity modifiers, and a narrow ledge of silicon has been created at its edges. This ledge 90 carries the intermediate layer 84 as a coating. Overlapping boron implant distributions can now be used to passivate the edge of the silicon island. The ledge 90 of the silicon island is protected by the intermediate layer which acts as a barrier to reduce the energy of the conductivity modifiers. Therefore a greater concentration of conductivity modifiers become -implanted in the region of the "two-gate effect" of the silicon island than in the prior art method. The hardened and the normal resists are subsequently easily removed in standard solvents.

Materials other than resist may be used to form the mask. Nitride material may be used. Resist is still used to protect any P-channel devices which were being fabricated in the semiconductor layer.

Although this procedure may lead to a non-passivated region at the extreme edges of the silicon island (due to implant penetration into the substrate 82), this region would not cause excessive leakage in standard SOS devices.

The passivation of edges in SOI structures is very difficult to do in an area efficient way, especially for radiation hard applications. In SOI structures there is an inherent region of positive charge at the silicon island/lower oxide interface. The region of positive charge will induce an inversion layer, that is a leakage path, in the very thin silicon towards the outer edge of the island. During irradiation the number of positive charges increases rapidly and a device which does not leak originally may do so later on. The invention is particularly suitable for this application.

Although the description above refers to the fabrication of FET devices the invention is not so limited. It may be used in any semiconductor fabrication process to modify an edge of a semiconductor material be it in the form of an island, or simply any surface upstanding from a substrate.

## Claims

1. A method of stabilising a semiconductor device the method comprising the steps of: forming a layer (44) of semiconductor material on a substrate (42); forming an intermediate layer (46) on the semiconductor layer (44); forming at least one mask region (48, 50) on a portion of the intermediate layer (46), the mask region being conductivity modifier impermeable; introducing conductivity modifiers (54) into unprotected regions (56, 58) of the semiconductor layer (44); changing the dimensions of the or each mask region (48, 50); and etching back unprotected regions of the semiconductor layer (44) to form at least one semiconductor island (66).

2. A method according to claim 1 in which the or each mask region (48, 50) is decreased in size.

3. A method according to claim 1 in which the or each mask region (48, 50) is increased in size.

4. A method according to claim 3 in which the or each mask region (48, 50) is increased in size by depositing at least one silicon nitride spacer along at least one mask side.

5. A method according to any preceding claim in which the intermediate layer (46) is conductivity modifier permeable.

6. A method according to any preceding claim in which there is a plurality of implants of conductivity modifiers (54).

7. A method according to any preceding claim in which overlapping distributions of conductivity modifiers (54) are introduced into the semiconductor layer (44).

8. A method according to any preceding claim in which an increased concentration of conductivity modifiers (54) is introduced in an upper region (24) of the semiconductor layer (44).

9. A method according to any preceding claim in which the or each mask region (48, 50) comprises a deposited oxide.

10. A semiconductor device made using a method in accordance with any preceding claim.
